(19) Europäisches Patentamt
European Patent Office
Office européen des brevets

(11) Publication number: 0 357 063 A2

(12) EUROPEAN PATENT APPLICATION

(21) Application number: 89116086.3

(51) Int. Cl.5: G03F 7/004

(22) Date of filing: 31.08.89

(30) Priority: 02.09.88 US 240883
07.08.89 US 388966

(43) Date of publication of application:
07.03.90 Bulletin 90/10

(84) Designated Contracting States:
DE FR GB IT

(71) Applicant: E.I. DU PONT DE NEMOURS AND COMPANY
1007 Market Street
Wilmington Delaware 19898(US)

(72) Inventor: Nebe, William John
2719 Tanager Drive Brookmeade III
Wilmington, Del. 19808(US)
Inventor: Osborne, James Jerry
609 Ridge Avenue
Kennett Square, PA 19348(US)
Inventor: Jolley, John Eric
20 Boulder Brook Drive
Wilmington, Del. 19803(US)

(74) Representative: von Kreisler, Alek, Dipl.-Chem. et al
Patentanwälte Von Kreisler-Selting-Werner
Deichmannhaus am Hauptbahnhof
D-5000 Köln 1(DE)

(54) **Photosensitive ceramic coating composition.**

(57) A photosensitive ceramic coating composition is disclosed which is fireable in a substantially nonoxidizing atmosphere.

EP 0 357 063 A2

Xerox Copy Centre

## PHOTOSENSITIVE CERAMIC COATING COMPOSITION CROSS-REFERENCE TO RELATED APPLICATION

The present application is a continuation-in-part of Serial No. 240,883 filed September 2, 1988.

### FIELD OF INVENTION

The invention relates to photosensitive ceramic coating compositions and, in particular, to such compositions in which the ceramic component is a dielectric material.

### BACKGROUND OF THE INVENTION

Multilayer thick film circuits have been used for many years to increase circuit functionality per unit of area. Moreover, recent advances in circuit technology have placed new demands on dielectric materials for this use. Heretofore, most of the dielectric materials used in multiple circuits have been conventional thick film dielectric compositions. These are comprised of finely divided particles of dielectric solids and inorganic binders dispersed in an inert organic medium. Such thick film materials are usually applied by screen printing, though they may be applied by other means as well.

Thick film materials of this type are very important and will continue to be so. However, when applying these thick film materials by screen printing, it is difficult to obtain better than 8 mil (203 micron) via resolution. In fact, to obtain even this level of performance, it is essential that all the screen printing variables such as screen quality, squeegee hardness, print speed, dispersion properties, etc., be most carefully controlled and constantly monitored to obtain good product yields. Similar problems exist, of course, with the use of thick film conductor and resistor materials.

One approach to this problem is (1) to apply a layer of the dielectric material to a substrate by means of a dispersion in a photosensitive medium, (2) to expose the layer imagewise to actinic radiation, (3) to solvent develop the pattern to remove unexposed portions of the layer, and (4) to fire the remaining exposed portions of the pattern to remove all remaining organic materials and to sinter the inorganic materials. This technique is revealed in several issued patents such as U.S. 3,443,944 to Wise, U.S. 3,615,457 to Seibert, U.S. 3,958,996 and U.S. 3,982,941 to Inskip, U.S. 3,877,950 to Felten and U.S. 3,914,128 to Scheiber et al. U.S. 3,355,291 to Baird et al. and U.S. 3,573,908 to Minetti describe a method for applying glass to a semiconductor device by applying a photosensitive paste of the glass, exposing, solvent developing and firing the exposed areas.

Although the prior art describes photosensitive dielectric pastes, there are several disadvantages with these pastes, namely drying, exposure, firing characteristics and latitude. There exists a need, therefore, for a paste which would reduce or eliminate the above-mentioned disadvantages and at the same time provide resolution of better than 8 mil lines and spaces.

### SUMMARY OF THE INVENTION

In its primary aspect, the invention is directed to a photosensitive ceramic coating composition which is fireable in a substantially nonoxidizing atmosphere comprising an admixture of:

(a) finely divided particles of ceramic solids having a surface area-to-weight ratio of no more than 10 $m^2/g$ and at least 80% by weight of the particles having a size of 1-10 microns,

(b) finely divided particles of an inorganic binder having a surface area-to-weight ratio of no more than 10 $m^2/g$ from 8 to 15% by weight of the particles have a particle size that is less than 1.0 micron and greater than 0.5 micron and from 85 to 92% by weight of the particles have a particle size in a range from 1 to 10 microns, the weight ratio of (b) to (a) being from 0.6 to 2.0, dispersed in an organic medium comprising

(c) an organic polymeric binder selected from the group consisting of (1) homopolymers and copolymers of $C_{1-10}$ alkyl acrylates, $C_{1-10}$ alkyl methacrylates, $\alpha$-methylstyrene and 0-2% by weight ethylenically unsaturated carboxylic acid, amine or silane-containing compounds, (2) homopolymers and

copolymers of $C_{1-10}$ monoolefins, (3) homopolymers and copolymers of $C_{1-4}$ alkylene oxide and mixtures thereof, the binder comprising 5-25% by weight, basis total inorganic solids,

(d) a photoinitiator system

(e) a photohardenable monomer, the monomer comprising 1-20% by weight, basis total inorganic solids,

(f) a dispersant represented by structure I

(I) 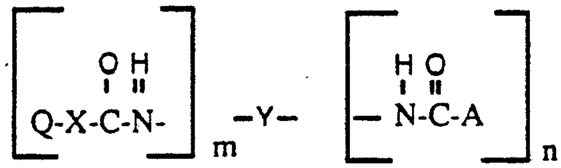

wherein

Q is a polymeric or copolymeric segment of

a. an ester of acrylic acid or methacrylic acid with an alkanol of 1-18 carbon atoms

b. styrene or acrylonitrile

c. a vinyl ester whose ester moiety contains 2-18 carbon atoms or

d. a vinyl ether

X is the residue of a chain transfer agent

Y is the residue of a di-, tri- or tetraisocyanate radical after removal of isocyanate groups

A is the residue of a basic radical which as an entity before reaction, has a pKa value of 5-14, or a salt thereof and

m and n are 1, 2 or 3, the total not exceeding 4, provided that when n is 2 or 3, only one of A need be as defined.

or structure II

(II) 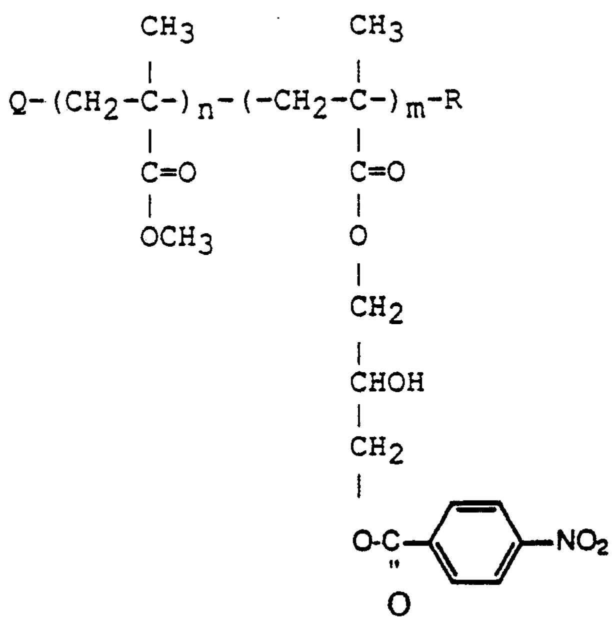

wherein

Q is an alkyl methacrylate polymeric segment containing about 20 units of butyl methacrylate,

n is 20,

m is 8 to 12 and

R is a chain terminator residue

(g) a plasticizer selected from the group consisting of dialkyl phthalates, aryl-alkyl phthalates, alkyl phosphates, polyalkylene glycols, glycerol, poly(ethylene oxides), hydroxy ethylated alkyl phenol, tricresyl phosphate triethyleneglycol diacetate, and polyester plasticizers, the plasticizer comprising 1-10% by weight, basis total inorganic solids, and

(h) a volatile nonaqueous organic solvent.

In a secondary aspect, the invention is directed to a method of making the above-described photosensitive ceramic coating composition wherein components (a) and (b) are freeze dried prior to mixing with components (c) through (h).

In a still further aspect, the invention is directed to a method of making the above-described photosensitive ceramic coating composition wherein components (a) and (b) are passed through a magnetic separator prior to mixing with components (c) through (h).

## DETAILED DESCRIPTION OF THE INVENTION

### A. Ceramic Solids

The invention is applicable to virtually any high melting inorganic solid material. However, it is particularly suitable for making dispersions of dielectric solids such as alumina, titanates, zirconates and stannates. It is also applicable to precursors of such materials, i.e., solid materials which upon firing are converted to dielectric solids, and to mixtures of any of these.

Among the many dielectric solids which are likely to be used in the invention are $BaTiO_3$, $CaTiO_3$, $SrTiO_3$, $PbTiO_3$, $CaZrO_3$, $BaZrO_3$, $CaSnO_3$, $BaSnO_3$, and $Al_2O_3$. As will be apparent to those skilled in the ceramic arts, the exact chemical composition of the ceramic solids to be used in the composition of the invention is not ordinarily critical in the rheological sense. It is also preferred that the ceramic solids not have swelling characteristics in the organic dispersion since the rheological properties of the dispersion may be substantially changed thereby.

It has been found that the dispersion of the invention must contain no significant amount of solids having a particle size of less than 0.3 microns in order to obtain adequately complete burnout of the organic medium when the films or layers thereof are fired to remove the organic medium and to effect sintering of the inorganic binder and the ceramic solids. However, none of the ceramic solids may exceed 20 microns and, furthermore, at least 75% by weight of the ceramic solids must have a size of 1-10 microns. When the dispersion is used to make thick film pastes, which are usually applied by screen printing, the maximum particle size must not exceed the thickness of the screen, and when the dispersion is used to make dry photosensitive film, the maximum particle size must not exceed the thickness of the film. It is preferred that at least 80% by weight of the ceramic solids fall within the 1-10 micron range.

A preferred particle size for the 50% point on the distribution curve ($D_{50}$), i.e., the point at which the weight of smaller particles equals the weight of larger particles, is in the range from 2.3 to 2.7 microns. This size range is needed to achieve a blister free surface while maintaining a hermetic structure. This particle size range must be the same or very close to that of the glass frit, 2.30 to 2.70 microns.

In addition, it is preferred that surface area/weight ratio of the ceramic particles not exceed 10 square meters per gram for the reason that such particles tend to affect adversely the sintering characteristics of the accompanying inorganic binder. It is still further preferred that the surface area/weight ratio not exceed 5 square meters per gram. Ceramic particles having a surface area/weight ratio of 1-5 have been found to be quite satisfactory.

A preferred material is alumina. A preferred procedure is to pass the milled water alumina slurry through a fine mesh screen (ex. 400 mesh) to remove large particles and also through a magnetic separator. The magnetic separator removes all magnetic conductive materials which otherwise would increase the conductivity of the final product.

Of critical importance is to achieve a ceramic solid composition which is agglomerate free. Normally after milling a ceramic, to achieve desired particle size distribution, the water or mixing solvent is removed by either vacuum assisted heating or heating in an air stream. This technique results in some of the ceramic particulates becoming agglomerated, resulting, after firing, in a part with large particulate clusters and/or blisters.

This particularly serious disadvantage is eliminated in a preferred procedure by freeze drying the milled alumina. The very mild conditions of freeze drying eliminates the potential for agglomeration which normally results when powders are heated. A similar technique is applicable for different ceramic solids.

B. Inorganic Binder

The glass frit used in the present invention aids in sintering the inorganic crystalline particulates and may be of any well known composition which has a melting temperature below that of the ceramic solids. Nevertheless, in order to get adequate hermeticity of the devices, it is preferred that the glass transition temperature ($T_g$) of the inorganic binder be 550-825 °C and still more preferably 575-750 °C. If melting takes place below 550 °C, organic material will likely be encapsulated and blisters will tend to form in the dielectric layer as the organics decompose. On the other hand, a glass transition temperature above 825 °C will tend to produce a porous dielectric when sintering temperatures compatible with copper metallizations, e.g., 900 °C, are used.

The glass frits most preferably used are the borosilicate frits, such as lead borosilicate frit, bismuth, cadmium, barium, calcium or other alkaline earth borosilicate frits. The preparation of such glass frits is well known and consists, for example, in melting together the constituents of the glass in the form of the oxides of the constituents and pouring such molten composition into water to form the frit. The batch ingredients may, of coarse, be any compound that will yield the desired oxides under the usual conditions of frit production. For example, boric oxide will be obtained from boric acid, silicon dioxide will be produced from flint, barium oxide will be produced from barium carbonate, etc.

The glasses are prepared by conventional glassmaking techniques, by mixing the desired components in the desired proportions and heating the mixture to form a melt. As is well known in the art, heating is conducted to a peak temperature and for a time such that the melt becomes entirely liquid and homogeneous. In the present work, the components are premixed by shaking in a polyethylene jar with plastic balls and then melted in a platinum crucible at the desired temperature. The melt is heated at the peak temperature for a period of 1 to 1.5 hours. The melt is then poured into cold water. The maximum temperature of the water during quenching is kept as low as possible by increasing the water-to-melt ratio. The crude frit after separation from water is freed of residual water by furnace drying in air or displacing the water by rinsing with methanol.

This coarse glass frit is then milled in water to reduce the particle size to approximately 2.5 microns. Thereafter the frit is preferably processed in a similar manner as the ceramic solids. The frit is passed through a 400-mesh screen to remove large particles and magnetically separated. The milled glass-water slurry is then freeze dried. As with the ceramic solids, drying by means other than freeze drying results in a powder contaminated with agglomerates.

The glass frit, like the ceramic solids, should have a surface-to-weight ratio of no more than 10 square meters per gram and should have no significant amount of particles having a size of less than 0.3 microns. As discussed for the ceramic solids, the glass particles should have a D50 that is the same as or very close to that of the ceramic solids.

However, these particle size and surface area limitations alone are not sufficient to ensure the production of a ceramic coating composition that will result in fired parts with good hermetic and physical properties. It has been found that this can be achieved by controlling the amount of submicron particles ("fines") in the dielectric composition. From about 8-15% by weight of the glass particles should have a particles size of less than 1.0 micron but greater than 0.5 micron. It is preferred that 10-12% of the glass particles be in this submicron range. When the concentration of submicron particles falls below about 8% by weight the fired ceramic dielectric will have reduced hermetic and insulating properties. If more than about 15% by weight submicron particles are present sintering begins before gas evolution has been completed during the firing step which results in blister formation.

The remaining 85-92% by weight of the glass particles should have a particle size of 1-10 microns. It is preferred that the particle size be 1-6 microns. Larger size particles tend to have poorer sintering characteristics.

The ratio of inorganic binder to ceramic solids is extremely critical to the production of a fired dielectric part with optimum capacitance. It is preferred that the particle size be 1-6 microns. Larger size particles tend to have poorer sintering characteristics.

The ratio of inorganic binder to ceramic solids is extremely critical to the production of a fired dielectric part with optimum capacitance. It is preferred that the ratio be 0.6 to 2.0, and most preferred that the ratio be 1.0. If the ratio is significantly higher, the dielectric layer tends to form blisters on firing. If the ratio is significantly lower, the fired dielectric will be porous and therefore nonhermetic.

C. Organic Polymeric Binder

As set out hereinabove, the binder component of the dispersion of the invention is an organic polymeric binder selected from the group consisting of (1) homopolymers and copolymers of $C_{1-10}$ alkyl acrylates, $C_{1-10}$ alkyl methacrylates, α-methylstyrene and 0-2% by weight ethylenically unsaturated carboxylic acid, amine or silane-containing compounds, (2) homopolymers and copolymers of $C_{1-10}$ mono-olefins, (3) homopolymers and copolymers of $C_{1-4}$ alkylene oxide and mixtures thereof, the binder comprising 5-25% by weight, basis total inorganic solids.

The above-described polymers include homopolymers as well as random copolymers and higher multipolymers. The relative quantity of carboxylic acid or amine distributed along the polymer chains should be no more than 2.0% by weight. Because they are cleaner burning in low-oxygen atmosphere, methacrylic polymers, especially polymethyl methacrylate), are preferred over acrylic polymers.

It is preferred that the comonomers containing functional moieties not exceed 10.0% by weight of any one polymer or 2.0% in the polymer mixture to avoid flocculation of the dispersed ceramic solids. In some instances, it has been observed that polymer mixtures having as low as 1.8% acid-containing monomers may be borderline or even unsatisfactory with respect to dispersion characteristics. In most instances of this kind, such polymers can, nevertheless, still be used in the invention by employing a more polar solvent. Thus, while a polymer mixture containing as much as 2.0% monomer-containing functional groups can be used, such polymer mixtures having only 1.5% functional monomers are preferred. No more than 1.0% by weight of such functional monomers is still further preferred. It is also preferred for the same reason that none of the polymers contained in the polymeric mixture contain more than 10.0% by weight functional comonomer. Thus, the polymeric binder can be a mixture of polymers, some of which contain no functional moieties at all and some of which contain as much as 10.0% by weight functional comonomers so long as the content of functional comonomers in the total mixture is within the range of 0.2-2.0% by weight. On the other hand, it is preferred that the polymeric binder be comprised mostly of methacrylic polymers as defined above which contain 0-5.0% by weight functional comonomer.

Suitable copolymerizable carboxylic acids include ethylenically unsaturated $C_{3-6}$ monocarboxylic acids such as acrylic, methacrylic and crotonic acids and $C_{4-10}$ dicarboxylic acids such as fumaric, itaconic, citraconic, vinyl succinic and maleic acids as well as their half esters and, where appropriate, their anhydrides and mixtures thereof. Because they are cleaner burning in low-oxygen atmospheres, methacrylic polymers are preferred over acrylic polymers.

It is, of course, recognized that certain amine constituents cannot be incorporated in the chain directly by copolymerization of the amine-containing monomer but may be incorporated indirectly by postpolymerization reaction of a pendant reactive moiety of the polymer chain. Illustrative of this are primary amines which can be added by reaction of glycidyl compounds with pendant carboxylic acid groups in the presence of ammonia. Thus, as used herein, the term "ethylenically unsaturated amine" is intended to include polymers derived from both amine-containing comonomer as well as other comonomers which have been postpolymerizationally reacted to from amine groups thereon. Primary, secondary and tertiary amines are each effective in a similar manner. Suitable comonomers for direct incorporation of pendant amine groups into the binder polymer chain include diethylaminoethyl methacrylate, dimethylaminoethyl methacrylate and t-butylaminoethyl methacrylate. Suitable comonomers which yield pendant functional moieties suitable for postpolymerization reaction to incorporate amine functionality include the above-described ethylenically unsaturated compounds viz. epoxides such as glycidyl acrylate or glycidyl methacrylate.

Within the above-described limits for the nonacidic comonomers, it is preferred that the alkyl acrylate or methacrylate constitute at least 75 and preferably 80% by weight of the polymer.

The polymeric binder can contain up to about 10% by weight of other nonacrylic and nonacidic comonomers such as styrene, acrylonitrile, vinyl acetate, acrylamide and the like, so long as the previously discussed compositional criteria are met as well as the physical criteria mentioned below. However, it is preferred to use not more than about 5% by weight of such monomers because they are more difficult to burn out cleanly. At present, the use of such other comonomers is not known to add to the efficacy of the copolymers in their application to the invention. However, such comonomer in the above-listed amounts do not detract from the effectiveness of the polymers so long as all the compositional and physical property criteria are met.

In addition to the above described acrylic and methacrylic polymers, various polyolefins such as polyethylene, polypropylene, polybutylene, polyisobutylene, and ethylene-propylene copolymers can also be used. Also useful in the invention are the so-called polyethers which are polymers of lower alkylene oxides, such as polyethylene oxide, polypropylene oxide and polybutylene oxide.

In addition to the above-described compositional parameters, certain physical properties of the polymeric binder are, of course, important. In particular, it will be recognized by those skilled in the photoresist art that the unexposed binder polymer must be substantially developable in whatever solvent developer is used. On the other hand, the photohardened binder must have sufficient solvent resistance that it is not washed off by the developer solvent.

Polymers meeting these criteria can be made by those skilled in the art of acrylate polymerization by conventional solution polymerization techniques. Typically, such acidic acrylate polymers are prepared by combining an alpha, beta-ethylenically unsaturated acid with one or more copolymerizable vinyl monomers in a relatively low boiling (75-150 °C) organic solvent to obtain a 20 to 60% solution of the monomer mixture, then subsequently causing the monomers to polymerize by the addition of a polymerization catalyst and heating the mixture at the reflux temperature of the solution at atmospheric pressure. After the polymerization reaction is essentially complete, the resulting acid polymer solution is cooled to room temperature and samples are removed to determine the viscosity, molecular weight, acid equivalent, etc. of the polymer.

### D. Photoinitiation System

Suitable photoinitiation systems are those which are thermally inactive but which generate free radicals upon exposure to actinic light at or below 85 °C. These include the substituted or unsubstituted polynuclear quinones which are compounds having two intracyclic carbon atoms in a conjugated carbocyclic ring system, e.g., 9,10-anthraquinone, 2-methylanthraquinone, 2-ethylanthraquinone, 2-t-butylanthraquinone, octamethylanthraquinone, 1,4-naphthoquinone, 9,10-phenanthrenequinone, benz(a)anthracene-7,12-dione, 2,3-naphthacene-5,12-dione, 2-methyl-1,4-naphthoquinone, 1,4-dimethyl-anthraquinone, 2,3-dimethylanthraquinone, 2-phenylanthraquinone, 2,3-diphenylanthraquinone, retenequinone, 7,8,9,10-tetrahydronaphthacene-5,12-dione, and 1,2,3,4-tetrahydrobenz(a)anthracene-7,12-dione. Other photoinitiators which are also useful, even though some may be thermally active at temperatures as low as 85 °C, are described in U.S. Patent 2,760,863 and include vicinal ketaldonyl alcohols, such as benzoin, pivaloin, acyloin ethers, e.g., benzoin methyl and ethyl ethers; alpha-hydrocarbon substituted aromatic acyloins, including alpha-methylbenzoin, alpha-allylbenzoin and alpha-phenylbenzoin. Photoreducible dyes and reducing agents disclosed in U.S. Patents 2,850,445, 2,865,947, 3,097,096, 3,074,974, 3,097,097, and 3,145,104, as well as dyes of the phenazine, oxazine, and quinone classes, Michler's ketone, benzophenone, 2,4,5-triarylimidizolyl dimers with hydrogen donors including leuco dyes and mixtures thereof as described in U.S. Patents 3,427,161, 3,479,185, and 3,549,367 can be used as initiators. Also useful with photoinitiators and photoinhibitors are sensitizers disclosed in U.S. Patent 4,162,162.

A preferred photoinitiator system comprises benzophenone and Michler's ketone. A most preferred photoinitiator system comprises benzophenone and Michler's ketone in a ratio of 6:1.

The photoinitiator or photoinitiator system is present in 0.05 to 12% by weight based on the total weight of inorganic solids.

### E. Photohardenable Monomer

The photohardenable monomer component of the invention is comprised of at least one addition polymerizable ethylenically unsaturated compound having at least one polymerizable ethylenic group. Such compounds are capable of forming a high polymer by free radical initiated, chain propagating addition polymerization. Preferably, the unsaturated compound (monomer) has at least two terminal ethylenically unsaturated groups, e.g., 2 to 4 groups. The monomeric compounds are nongaseous. That is, they have a normal boiling point above 100 °C and a plasticizing action on the organic polymeric binder.

Suitable monomers which can be used alone or in combination with other monomers include t-butyl acrylate and methacrylate, 1,5-pentanediol diacrylate and dimethacrylate, N,N-diethylaminoethyl acrylate and methacrylate, ethylene glycol diacrylate and dimethacrylate, 1,4-butanediol diacrylate and dimethacrylate, diethylene glycol diacrylate and dimethacrylate, hexamethylene glycol diacrylate and dimethacrylate, 1,3-propanediol diacrylate and dimethacrylate, decamethylene glycol diacrylate and dimethacrylate, 1,4-cyclohexanedioldiacrylate and dimethacrylate, 2,2-dimethylolpropanediacrylate and dimethacrylate, glycerol diacrylate and dimethacrylate, tripropylene glycol diacrylate and dimethacrylate,

glycerol triacrylate and trimethacrylate, trimethylolpropane triacrylate and trimethacrylate, pentaerythritol triacrylate and trimethacrylate, polyoxyethylated triacrylate and trimethacrylate, and similar compounds as disclosed in U.S. Patent 3,380,831, 2,2-di(p-hydroxyphenyl)-propane dimethacrylate, triethylene glycol diacrylate polyoxyethyl-2,2-di-(p-hydroxyphenyl)propane dimethacrylate, di-(3-methacryloxy-2-hydroxypropyl) ether of bisphenol-A, di-(2-methacryloxyethyl) ether of bisphenol-A, di-(3-acryloxy-2-hydroxypropyl) ether of bisphenol-A, di-(2-acryloxyethyl) ether of bisphenol-A, di-(3-methacryloxy-2-hydroxypropyl) ether of 1,4-butanediol, triethylene glycol dimethacrylate, polyoxypropyltrimethylol propane triacrylate, butylene glycol diacrylate and dimethacrylate, 1,2,4-butanetriol triacrylate and trimethacrylate, 2,2,4-trimethyl-1,3-pentanediol diacrylate and dimethacrylate, 1-phenyl ethylene-1,2-dimethacrylate, diallyl fumarate, styrene, 1,4-benzenediol dimethacrylate, 1,4-diisopropenyl benzene, and 1,3,5-triisopropenyl benzene. Also useful are ethylenically unsaturated compounds having a molecular weight of at least 300, e.g., alkylene or a polyalkylene glycol diacrylate prepared from an alkylene glycol of 2 to 15 carbons or a polyalkylene ether glycol of 1 to 10 ether linkages, and those disclosed in U.S. Patent 2,927,022, e.g., those having a plurality of addition polymerizable ethylenic linkages, particularly when present as terminal linkages. Preferred monomers are ethylated pentaerythritol triacrylate, dipentaerythritol monohydroxypentaacrylate and 1,10-decanediol dimethacrylate. The unsaturated monomeric component is present in an amount of 5 to 45% by weight based on the total weight of the dry photopolymerizable layer.

A particularly preferred photohardenable monomer because of its superior screen printing and paste drying characteristics is polyoxyethylated trimethylol propane triacrylate (TEOTA).

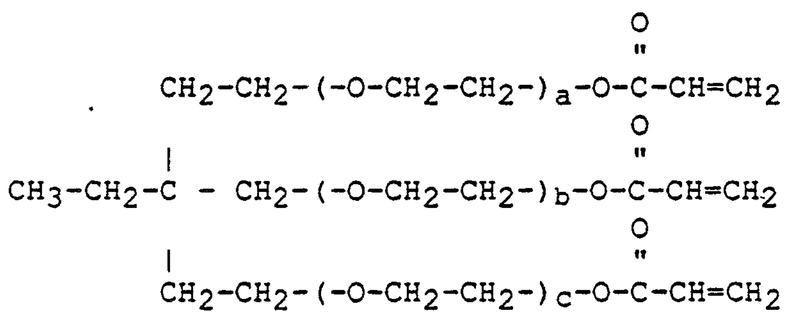

TEOTA

The molecular weight of TEOTA can be from about 1000 to 2000. A molecular weight of 1000 is preferred.

A most preferred monomer is the trimethacrylate ester of polyoxyethylated trimethylol propane (TEOTMA).

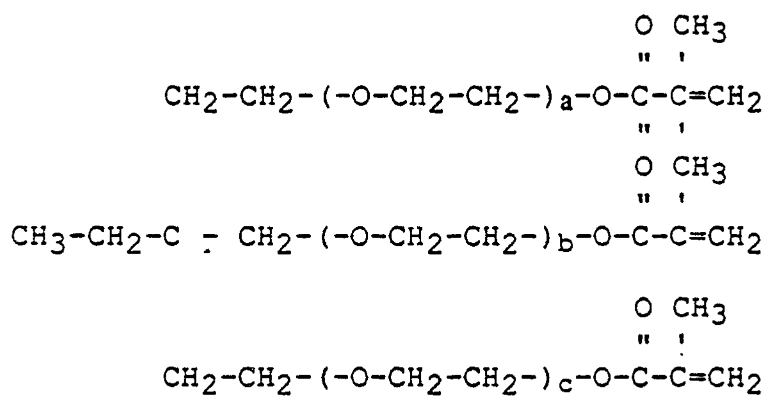

TEOTMA

This monomer gives excellent paste drying characteristics, due to its higher boiling point, improved burnout and improved development latitude. It is believed that this is due to the superior plasticizing capability of TEOTMA which promotes more thorough polymerization in the areas exposed to actinic radiation and results in greater solubility in the unexposed areas. In addition, methacrylates appear to

degrade more efficiently under nitrogen firing conditions than acrylates leading to improved burnout.

F. Dispersant

A dispersant is added to insure the efficient wetting of the inorganic particles by the organic polymers and monomers. A thoroughly dispersed inorganic is desirable to the preparation of a photoactive paste with the needed characteristics of good screen printing and leveling and fire out characteristics. The dispersant acts to allow the polymeric binder to associate or wet the inorganic solids, giving an agglomerate free system.

The dispersants of choice are the A-B dispersants generally described in "Use of A-B Block Polymers as Dispersants for Non-aqueous Coating Systems" by H. L. Jakubauskas, Journal of Coating Technology, Vol. 58, Number 736, pages 71-82. Useful A-B dispersants are disclosed in U.S. Patents 3,684,771; 3,788,996; 4,070,388 and 4,032,698 and U.K. Patent 1,339,930, each of which is incorporated herein by reference.

A preferred class of A-B dispersants is disclosed in U.S. Patent 4,032,698 supra, represented by the structure

(I) 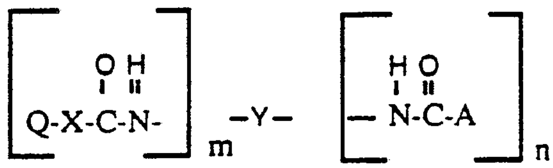

wherein

Q is a polymeric or copolymeric segment of

a. an ester of acrylic acid or methacrylic acid with an alkanol of 1-18 carbon atoms

b. styrene or acrylonitrile

c. a vinyl ester whose ester moiety contains 2-18 carbon atoms or

d. a vinyl ether X is the residue of a chain transfer agent

Y is the residue of a di-, tri- or tetraisocyanate radical after removal of isocyanate groups

A is the residue of a basic radical which as an entity before reaction, has a pKa value of 5-14, or a salt thereof and

m and n are 1, 2 or 3, the total not exceeding 4, provided that when n is 2 or 3, only one of A need be as defined.

A particularly preferred member of this class is a polymeric material, hereinafter identified as A-B Dispersant I, represented by the structure

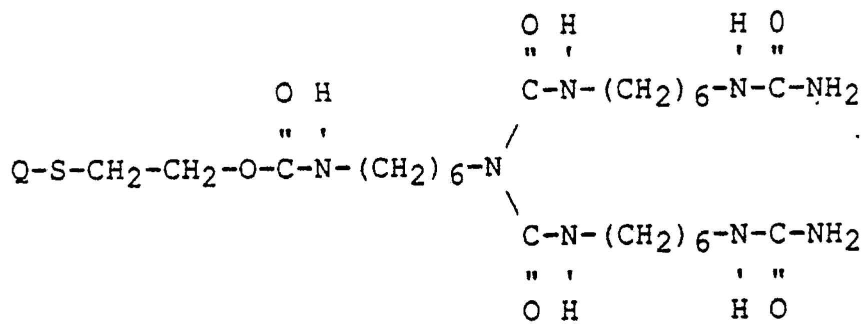

wherein

Q is a methylmethacrylate polymeric segment having a weight average molecular weight between 6000 and 8000.

Also particularly preferred is a member of a class of polymeric materials represented by the structure

(II) 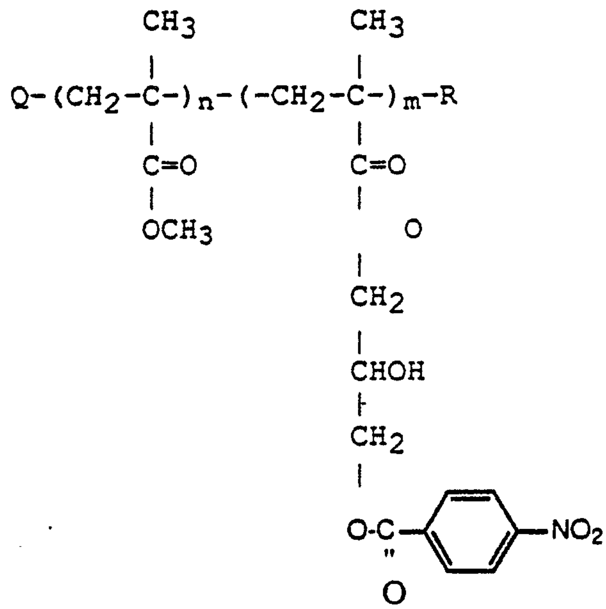

wherein
Q is an alkyl methacrylate polymeric segment containing about 20 units of butyl methacrylate,
n is 20,
m is 8 to 12 and
R is a chain terminator residue.
This dispersant is hereinafter identified as A-B Dispersant II.

### G. Plasticizer

In order to obtain the required resolution, it is critical that the coating composition contain a plasticizer which lowers the Tg of the binder polymer. Plasticizers help to assure good lamination to ceramic substrates and enhance developability. The plasticizer promotes more thorough polymerization in the areas exposed to actinic radiation and increases the solubility of the unexposed areas. The choice of plasticizers is, of course, determined primarily by the polymer which must be modified. Among the plasticizers which have been used in various binder systems are dialkyl phthalates such as diethyl phthalate and dibutyl phthalate; diaryl phthalates such as dibenzyl phthalate; alkyl-aryl phthalates such as butyl benzyl phthalate and octyl benzyl phthalate; alkyl phosphates; polyalkylene glycols; glycerol; poly(ethylene oxides); hydroxy ethylated alkyl phenol; tricresyl phosphate, triethyleneglycol diacetate; and polyester plasticizers. A preferred plasticizer is octyl benzyl phthalate. The plasticizer should be present in an amount of from 1-10% by weight basis total inorganic solids. Preferably the plasticizer is present in an amount of from 2-4% by weight.

Minor amounts of other components can be present in the photopolymerizable composition, e.g., pigments, dyes, thermal polymerization inhibitors, adhesion promoters, such as organosilane coupling agents, coating aids such as polyethylene oxides, etc., so long as the photopolymerizable compositions retain their essential properties. Organosilanes are particularly useful in quantities of 3.0% by weight or less based on the weight of the inorganic particles. Treated particles have a lower demand for organics. Thus, the level of organics in the coating can be reduced, which results in easier burnout upon firing. The organosilane can also improve the dispersion properties and allow a lower inorganic binder/ceramic solids ratio at equivalent hermeticity.

### H. Organic Medium

The main purpose of the organic medium is to serve as a vehicle for dispersion of the finely divided

solids of the composition in such form that it can readily be applied to a ceramic or other substrate. Thus, the organic medium must first be one in which the solids are dispersible with an adequate degree of stability. Secondly, the rheological properties of the organic medium must be such that they lend good application properties to the dispersion. Conventional thick film organic media can be used with appropriate rheological adjustments and the use of lower volatility solvents.

The thick film compositions of the invention will usually be applied to a substrate by means of screen printing. Therefore, they must have appropriate viscosity so that they can be passed through the screen readily. While the rheological properties are of primary importance, the organic medium is preferably formulated also to give appropriate wettability of the solids and the substrate, good drying rate, dried film strength sufficient to withstand rough handling and good firing properties. Satisfactory appearance of the fired composition is also important.

In view of all these criteria, a wide variety of inert liquids can be used as organic media. The organic medium for most thick film composition is typically a solution of resin in a solvent. The solvent usually boils within the range of 130-350 °C.

The most widely used solvents for thick film applications are terpenes such as alpha- or beta-terpineol or mixtures thereof with other solvents such as kerosene, butyl carbitol acetate, hexamethylene glycol and high boiling alcohols and alcohol esters. Various combinations of these and other solvents are formulated to obtain the desired viscosity and volatility requirements for each application.

The ratio of organic medium to inorganic solids in the dispersions can vary considerably and depends upon the manner in which the dispersion is to be applied and the kind of organic medium used. Normally, to achieve good coverage, the dispersions will contain complementally by weight 40-90% solids and 60-10% organic medium. Such dispersions are usually of semifluid consistency and are referred to commonly as "pastes".

The pastes are conveniently prepared on a three-roll mill. The viscosity of the pastes is typically within the following ranges when measured at room temperature on a Brookfield viscometer:

| Shear Rate (Sec-1) | Viscosity (Pa.s) |
|---|---|
| 0.5 | 60-120 |
| 2.0 | 60-120 |
| 10.0 | 60-120 |

The paste is designed to be Newtonian, a requirement which is necessary to permit leveling of the paste after it has passed thorough the screen when being screen printed. Polyacrylates as the organic binders of the paste yield Newtonian flow. The amount and type of organic medium utilized is determined mainly by the final desired formulation viscosity and print thickness.

Various dyes and pigments may also be added to increase visibility of the photo image. Any colorant used, however, should preferably be transparent to the actinic radiation used, although it may be opaque or strongly absorb other radiation in the visible or UV spectral region.

In addition to the many parameters of properties and composition described above, it is also essential that all of the components--both. inorganic and organic--be substantially free of halogens. The reason for this is that under normal firing conditions, halogenated compounds cause corrosion of adjoining conductive layers as well as the surfaces of the furnace in which they are fired.

## EXAMPLES

### Component Materials

In the examples which are set out below, the following component materials were used having the indicated properties:

A. Inorganics

Glass Frit: Ferro Glass #3467 milled in water, to a particle size range $D_{50}$ of 2.3-2.7 microns, magnetically separated, and freeze dried; composition (component mole %): lead oxide (5.6), silicon dioxide (68.1), boron oxide (4.7), alumina (6.5), calcium oxide (11.1), sodium oxide (2.8) and potassium oxide (1.3).
Alumina: Aluminum oxide ($Al_2O_3$); particle size $D_{50}$ 2.3-2.7, surface area 3.5-4.5 $m^2/g$.
Pigment: cobalt aluminate ($CoAl_2O_4$)

B. Polymeric Binders

Copolymer of 98% methylmethacrylate, 2% methacrylic acid; Mw = 25M, acid No. of 9, inherent viscosity * 0.183 ± 0.011, $T_g$ = 106 °C

C. Photoinitiator

Benzophenone
Michler's Ketone
2-t-Butylanthraquinone

D. Monomers

TEOTA 1000: Polyoxyethylated trimethylolpropane triacrylate; $M_w$ = 1162
TEOTMA 1100: Polyoxyethylated trimethylolpropane trimethacrylate; $M_n$ = 1200

E. Dispersant

A-B Dispersant I: see description above
A-B Dispersant II: see description above

F. Plasticizer

Santicizer® S-261: Octyl benzyl phthalate, Monsanto Inc., St. Louis, MO

G. Solvent

n-Butyl carbitol acetate

H. Other

Antioxidant Ionol®: 2,6-di-t-butyl-4-methylphenol, Shell Chemical Co., Houston, TX

Preparation of Dielectric Paste

Inherent viscosity of a solution that contains 0.25 g polymer in 50 ml of methylene chloride measured at 20°C using a No. 50 Cannon-Fenske viscometer.

A. Preparation of Organic Vehicle

The organic components, the solvent and acrylic polymer were mixed in the amounts indicated below (parts by weight) and heated with stirring to 135 °C. Heating and stirring was continued until all the acrylic polymer had dissolved. The solution was then cooled to 100 °C and the initiator system and Ionol® added. This mixture was then stirred at 100 °C until the solids had dissolved, after which the solution was passed through a 400 mesh filter and allowed to cool.

| Ingredient | Vehicle I | Vehicle II |
|---|---|---|
| n-butyl carbitol acetate | 54.3 | 54.3 |
| acrylic polymer | 40.0 | 40.0 |
| 2-t-butyl anthraquinone | 5.4 | -- |
| benzophenone | -- | 4.8 |
| Michler's ketone | -- | 0.8 |
| Ionol® | 0.3 | 0.3 |

B. Preparation of Dielectric Inorganics--Glass Frit

The glass frit, Ferro 3467, 8 kg, was milled in 8 liters of water in a Sweco Mill, using alumina cylinders which were 0.5 inches in both diameter and length. This was done for 16 hours to achieve a D50 particle size distribution of 2.3-2.7 microns. The frit water mixture was then passed through a 400 mesh screen and passed through a S. G. Franz Model 241F2 Magnetic Separator at a DC setting of 11.5 V and 30 amps.

The glass frit mixture was freeze dried using a Virtis Consol 12 Freeze Drier. This procedure required about three days to remove all the water. The resulting powder was free-flowing and agglomerate free. The glass frit particle size distribution was (a) 10% by weight had a particle size of less than 1.0 microns but greater than 0.5 microns and (b) 90% by weight had a particle size in the range of I to 10 microns.

Ceramic--Alumina

The alumina, 8 kg, was milled in 8 liters of water for 14-16 hours in a Sweco Mill using alumina cylinders that were 0.5 inches both in length and diameter. This resulted in particles with a $D_{50}$ of from 2.3-2.7 microns. The water alumina mixture was passed through a 400 mesh screen and then passed through a S. G. Franz Model 241F2 Magnetic Separator at D.C. setting of 11.5 V and 30 amps. The water alumina mixture was freeze dried using a Virtis Consol 12 Freeze Drier. This procedure required approximately three days to remove the water. The resulting alumina powder was free-flowing and agglomerate free.

Alumina-Cobalt Aluminate

The alumina, 8 kg, and cobalt aluminate pigment, 144 grams, were mixed in 8 liters of water and milled in the Sweco Mill for one hour using alumina cylinders of 0.5 inches in both length and diameter. The milled alumina-pigment mixture was passed through a 400 mesh screen and then through an S. G. Franz Model 241F2 Magnetic Separator at a D.C. setting of 11.5 V and 30 amps. The mixture was freeze dried in a Virtis Consol 12 Freeze Drier for approximately three days. The resulting material was a free flowing powder which was agglomerate free.

C. Paste Formulation

The dielectric paste was prepared, under yellow light, by mixing the organic vehicle, monomer, dispersant and plasticizer into a mixing vessel. The glass frit and alumina/cobalt aluminate mixture was then added. The composition was then mixed for 30 minutes. The mixture was aged for approximately 12 hours and then roll milled using a three roll mill, at a roll pressure of 400 psi. Usually five passes through the mill were sufficient to thoroughly mix the composition. The paste was then screened through a 400 mesh screen. The paste viscosity at this point was in a range of 300-600 Pa.s. The viscosity was adjusted by the addition of n-butyl carbitol acetate to 80-120 Pa.s. This viscosity range was optimum for screen printing.

## D. Process Conditions

Care must be taken to avoid dirt contamination in the process of preparing coating compositions and in preparing dielectric parts since such contamination can lead to defects in the fired dielectric, The process work is best done in a Class-100 clean room.

The paste was applied to 2x2 ceramic parts by screen printing using a 325 mesh patterned screen. The parts were dried at between 75 and 100 °C in an air atmosphere oven. A nitrogen atmosphere could also be used. The dried coating had a thickness of 20 microns. A second screen printing gave a dried thickness of 40 microns.

The parts were exposed with a 500 watt lightsource (Hybrid Technology Group, Model 86-5). The optimum exposure time was determined from an exposure series that yielded information on the best exposure to yield the correct size vias or photoformed holes in the dielectric after development.

The exposed parts were developed using a spin developer using a 6-8 second, 50 psi spray of chlorothene developer with the part spinning at 2500 rpm, followed by a 2-10 second air stream at 50 psi to dry the part. The developer was sprayed perpendicular to the spinning part. A flat-spray jet pattern was obtained with a 0.125 inch (0.318 cm) JJ air atomizing nozzle from Spraying Systems Co., Wheaton, IL with setup J23 as described in Industrial Catalog 27. The solvent flow may be 50 to 2000 ml/minute, preferably 300 ml/minute. The nozzle-to-part distance may be 0.5 in. (1.27 cm) to 8 in. (20.35 cm) with a typical distance being 1.5 in (3.81 cm).

The developed parts were dried in a forced draft oven at 75 °C for 15 minutes and fired in a furnace with peak temperature of 900 °C over a two-hour cycle. In firing the composition of the invention, they were exposed to a substantially nonoxidizing atmosphere up to the glass transition temperature of the inorganic binder and to an essentially completely nonoxidizing atmosphere during the sintering phase of the firing step.

By the term "substantially nonoxidizing atmosphere" is meant an atmosphere which contains insufficient oxygen to effect any significant oxidation of copper metal, but which nevertheless contains sufficient oxygen to effect oxidation of the organic materials. In practice, it has been found that a nitrogen atmosphere of 100-1000 ppm $O_2$ is appropriate in the presintering phase of the firing step. From 300 to 800 ppm $O_2$ is preferred. The amount of oxygen is increased as the thickness of the dielectric layer increases. For two layers of dielectric paste that fire out to 20 microns, 300 to 400 ppm $O_2$ is sufficient. On the other hand, the essentially completely nonoxidizing atmosphere used during the glass sintering step of the firing refers to a nitrogen atmosphere containing only residual amounts of $O_2$, e.g., about 10 ppm. It is preferred to fire the composition of the invention at low heating rates in order to minimize physical defects in the fired layer.

The resolution was determined by exposing the dried photosensitive coatings through a test mask which contained holes of different sizes. The exposed parts were then developed as described above. The developed parts were then examined by microscope and the size of the holes measured on both the top and the bottom. An acceptable hole was one in which the difference between the diameter of the hole at the top and at the bottom was 1 mil or less. Unacceptable holes were much smaller at the bottom than at the top, or were completely plugged at the bottom. The resolution was taken to be the smallest hole that printed acceptably.

## Examples 1-4

The ceramic coating compositions were prepared using the ingredients given in Table 1. They were processed as described above and the resolution was determined. The results are given in Table 2.

Comparative Example 5

A ceramic coating composition without plasticizer was prepared using the ingredients given in Table 1. The composition was processed as described above and the resolution was determined. The results are given in Table 2.

Table 1

| Ingredient | 1 | 2 | 3 | 4 | 5 |
|---|---|---|---|---|---|
| $Al_2O_3/CoAl_2O_4$ | 27.6 | 27.6 | 27.6 | 27.6 | 27.6 |
| Glass frit | 27.4 | 27.4 | 27.4 | 27.4 | 27.4 |
| Vehicle I | -- | -- | -- | -- | 31.0 |
| Vehicle II | 31.0 | 31.0 | 31.0 | 31.0 | -- |
| TEOTA | 10.6 | 10.6 | -- | -- | 8.6 |
| TEOTMA | -- | -- | 10.6 | 10.6 | -- |
| A-B Dispersant I | 2.1 | -- | 2.1 | -- | -- |
| A-B Dispersant II | -- | 2.1 | -- | 2.1 | 2.1 |
| Plasticizer | 2.0 | 2.0 | 2.0 | 2.0 | |
| N-Butyl carbitol acetate | -- | -- | -- | -- | 3-5 |

Table 2

| | Resolution |
|---|---|
| Example 1 | 4-5 mil vias |
| Example 2 | 4-5 mil vias |
| Example 3 | 4-5 mil vias |
| Example 4 | 4-5 mil vias |
| Comparative Example 5 | 8-10 mil vias |

**Claims**

1. A photosensitive ceramic coating composition which is fireable in a substantially nonoxidizing atmosphere comprising an admixture of:

(a) finely divided particles of ceramic solids having a surface area-to-weight ratio of no more than 10 $m^2/g$ and at least 80% by weight of the particles having a size of 1-10 microns,

(b) finely divided particles of an inorganic binder having a surface area-to-weight ratio of no more than 10 $m^2/g$ from 8 to 15% by weight of the particles have a particle size that is less than 1.0 micron and greater than 0.5 micron and from 85 to 92% by weight of the particles have a particle size in a range from 1 to 10 microns, the weight ratio of (b) to (a) being from 0.6 to 2.0, dispersed in an organic medium comprising

(c) an organic polymeric binder selected from the group consisting of (1) homopolymers and copolymers of $C_{1-10}$ alkyl acrylates, $C_{1-10}$ alkyl methacrylates, $\alpha$-methylstyrene and 0-2% by weight ethylenically unsaturated carboxylic acid, amine or silane-containing compounds, (2) homopolymers and copolymers of $C_{1-10}$ monoolefins, (3) homopolymers and copolymers of $C_{1-4}$ alkylene oxide and mixtures thereof, the binder comprising 5-25% by weight, basis total inorganic solids,

(d) a photoinitiator system

(e) a photohardenable monomer, the monomer comprising 1-20% by weight, basis total inorganic solids,

(f) a dispersant represented by the structure I

(I) 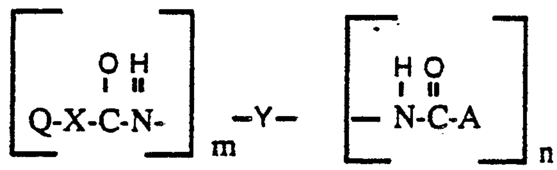

wherein

Q is a polymeric or copolymeric segment of

a. an ester of acrylic acid or methacrylic acid with an alkanol of 1-18 carbon atoms

b. styrene or acrylonitrile

c. a vinyl ester whose ester moiety contains 2-18 carbon atoms or

d. a vinyl ether

X is the residue of a chain transfer agent

Y is the residue of a di-, tri- or tetraisocyanate radical after removal of isocyanate groups

A is the residue of a basic radical which as an entity before reaction, has a pKa value of 5-14, or a salt thereof and

m and n are 1, 2 or 3, the total not exceeding 4, provided that when n is 2 or 3, only one of A need be as defined.

or structure II

(II) 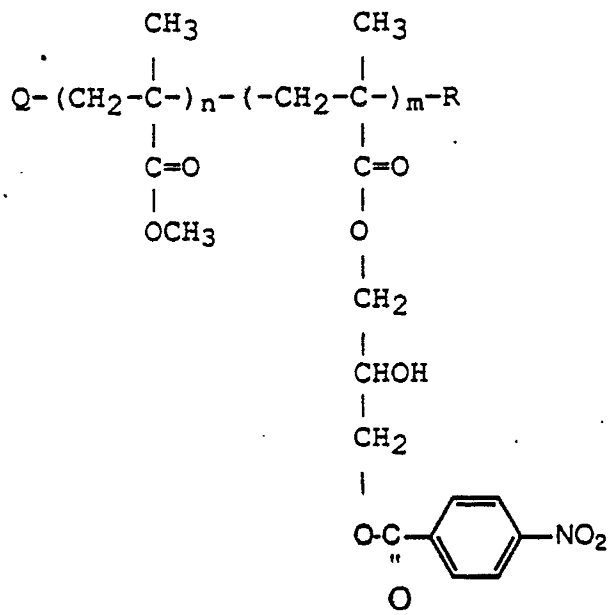

wherein

Q is an alkyl methacrylate polymeric segment containing about 20 units of butyl methacrylate,

n is 20,

m is 8 to 12 and

R is a chain terminator residue

(g) a plasticizer selected from the group consisting of dialkyl phthalates, aryl-alkyl phthalates, alkyl phosphates, polyalkylene glycols, glycerol, poly(ethylene oxides), hydroxy ethylated alkyl phenol, tricresyl phosphate, triethyleneglycol diacetate, and polyester plasticizers, the plasticizer comprising 0.5-10% by weight, basis total inorganic solids, and

(h) a volatile nonaqueous organic solvent.

2. The composition of claim 1 in which the plasticizer is octyl benzyl phthalate.

3. The composition of claim 1 in which the organic polymeric binder is a copolymer of 98% by weight methylmethacrylate and 2% by weight methacrylic acid.

4. The composition of claim 1 in which the photohardenable monomer is selected from the group consisting of polyoxyethylated trimethylol propane triacrylate and polyoxyethylated trimethylol propane trimethacrylate.

5. The composition of claim 1 in which the photoinitiation system comprises benzophenone and Michler's Ketone in a 6 to 1 ratio by weight.

6. The composition of claim 1 in which the dispersant is represented by the structure

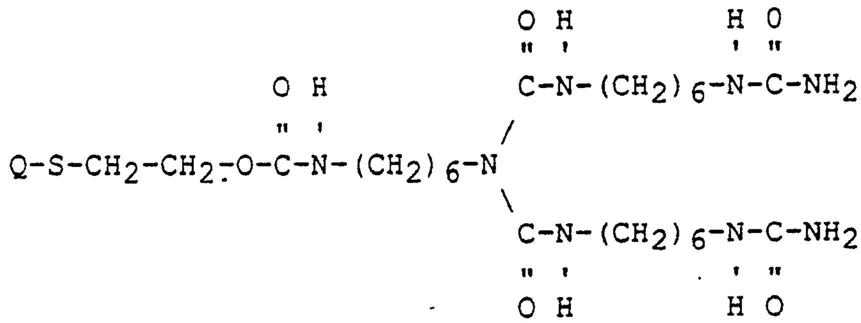

wherein
Q is a methylmethacrylate polymeric segment having a weight average molecular weight between 6000 and 8000.

7. In a method of making a photosensitive ceramic coating composition which is fireable in a substantially nonoxidizing atmosphere comprising an admixture of:

(a) finely divided particles of ceramic solids having a surface area-to-weight ratio of no more than 10 $m^2/g$ and at least 80% by weight of the particles having a size of 1-10 microns,

(b) finely divided particles of an inorganic binder having a surface area-to-weight ratio of no more than 10 $m^2/g$ from 8 to 15% by weight of the particles have a particle size that is less than 1.0 micron and greater than 0.5 micron and from 85 to 92% by weight of the particles have a particle size in a range from 1 to 10 microns, the weight ratio of (b) to (a) being from 0.6 to 2.0, dispersed in an organic medium comprising

(c) an organic polymeric binder selected from the group consisting of (1) homopolymers and copolymers of $C_{1-10}$ alkyl acrylates, $C_{1-10}$ alkyl methacrylates, α-methylstyrene and 0-2% by weight ethylenically unsaturated carboxylic acid, amine or silane-containing compounds, (2) homopolymers and copolymers of $C_{1-10}$ monoolefins, (3) homopolymers and copolymers of $C_{1-4}$ alkylene oxide and mixtures thereof, the binder comprising 5-25% by weight, basis total inorganic solids,

(d) a photoinitiator system

(e) a photohardenable monomer, the monomer comprising 1-20% by weight, basis total inorganic solids,

(f) a dispersant represented by structure I

(I) 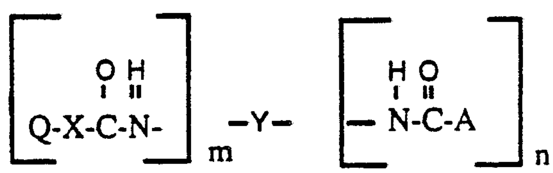

wherein
Q is a polymeric or copolymeric segment of
a. an ester of acrylic acid or methacrylic acid with an alkanol of 1-18 carbon atoms
b. styrene or acrylonitrile
c. a vinyl ester whose ester moiety contains 2-18 carbon atoms or
d. a vinyl ether
X is the residue of a chain transfer agent
Y is the residue of a di-, tri- or tetraisocyanate radical after removal of isocyanate groups
A is the residue of a basic radical which as an entity before reaction, has a pKa value of 5-14, or a salt thereof and
m and n are 1, 2 or 3, the total not exceeding 4, provided that when n is 2 or 3, only one of A need be as defined.
or structure II

(II) 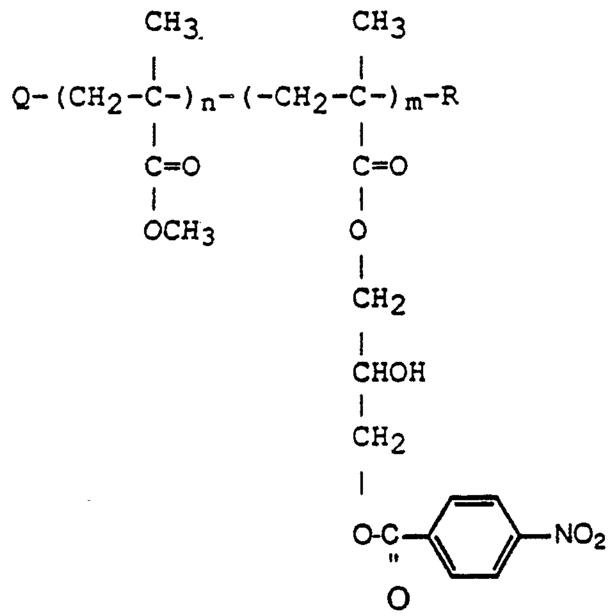

wherein
Q is an alkyl methacrylate polymeric segment containing about 20 units of butyl methacrylate,
n is 20,
m is 8 to 12 and
R is a chain terminator residue

(g) a plasticizer selected from the group consisting of dialkyl phthalates, aryl-alkyl phthalates, alkyl phosphates, polyalkylene glycols, glycerol, poly(ethylene oxides), hydroxy ethylated alkyl phenol, tricresyl phosphate triethyleneglycol diacetate, and polyester plasticizers, the plasticizer comprising 1-10% by weight, basis total inorganic solids, and

(h) a volatile nonaqueous organic solvent, wherein prior to the mixing of component (a), (b), (c), (d), (e), (f), (g) and (h), component (a) of finely divided particles. of ceramic solids and component (b) of finely divided particles of an inorganic binder are freeze dried in formation of such particles.

8. The method of claim 8 wherein component (a) of finely divided particles of ceramic solids and component (b) of finely divided particles of an inorganic binder are passed through a magnetic separator.